# EUROPÄISCHE PATENTSCHRIFT

(11) **EP 3 667 390 B1**
(45) Veröffentlichungstag und Bekanntmachung des Hinweises auf die Patenterteilung: **17.07.2024**
(21) Anmeldenummer: 19215791.5
(22) Anmeldetag: 12.12.2019
(51) Int. Cl.: G02B 21/00, G02F 1/11

(54) **VERFAHREN UND SIGNALGENERATOR ZUM ANSTEUERN EINES AKUSTOOPTISCHEN ELEMENTS**
METHOD AND SIGNAL GENERATOR FOR CONTROLLING AN ACOUSTO-OPTICAL ELEMENT
PROCÉDÉ ET GÉNÉRATEUR DE SIGNAL DESTINÉS À ENTRAÎNER UN ÉLÉMENT ACOUSTO-OPTIQUE

(30) Priorität: 14.12.2018 DE 102018132327
(43) Veröffentlichungstag der Anmeldung: 17.06.2020
(73) Patentinhaber: Leica Microsystems CMS GmbH, 35578 Wetzlar (DE)
(72) Erfinder: Widzgowski, Bernd, 69221 Dossenheim (DE)
(74) Vertreter: Dehns Germany Partnerschaft mbB

(56) Entgegenhaltungen:
- WO-A1-2017/207664
- WO-A1-2018/197546
- DE-A1- 102013 201 968
- GB-A- 2 427 034
- JP-A- 2000 149 337

## Beschreibung

Die vorliegende Erfindung betrifft ein Verfahren und einen Signalgenerator zum Ansteuern eines akustooptischen Elements, eine Anordnung aus einem solchen Signalgenerator und einem akustooptischen Element sowie ein Mikroskop mit einer solchen Anordnung.

### Stand der Technik

Eine wesentliche Herausforderung in Bereichen der Mikroskopie ist, unabhängig vom eingesetzten Verfahren, die Bereitstellung von Anregungslicht mit einer oder mehreren vorgegebenen Wellenlängen. Je nach Art des Mikroskopieverfahrens und/oder nach Art der Probe können ein oder mehrere Anregungslichtstrahlen, welche in der Regel vorgegebene spektrale Eigenschaften aufweisen müssen, notwendig sein.

Beispielsweise ist es auf dem Gebiet der Fluoreszenzmikroskopie wichtig, Licht mit derjenigen Wellenlänge zu verwenden, die die Fluoreszenz anregt. Verschiedene Wellenlängen werden insbesondere dann gebraucht, wenn die Probe Fluoreszenzstoffe mit unterschiedlichen Emissionswellenlängen enthält.

Auf dem Gebiet der konfokalen Rastermikroskopie ist es von besonderem Interesse, die Intensitäten für bestimmte Wellenlängen anzupassen oder bestimmte Wellenlängen ein- oder auszuschalten.

Zu diesem Zweck können wellenlängenselektive Elemente zum Einsatz kommen, welche auf dem akustooptischen Effekt basieren. Derartige akustooptische Elemente weisen in der Regel einen sogenannten akustooptischen Kristall auf, welcher mittels eines akustischen Signalgebers, auch als Wandler oder "Transducer" bezeichnet, in Schwingung versetzt wird. In der Regel weist ein derartiger Wandler ein piezoelektrisches Material sowie zwei oder mehrere dieses Material kontaktierende Elektroden auf. Durch elektrisches Beschalten der Elektroden mit Hochfrequenzen, die typischerweise im Bereich zwischen 10 MHz und wenigen GHz liegen, wird das piezoelektrische Material zum Schwingen angeregt, so dass eine akustische Welle entstehen kann, die den Kristall durchläuft. Akustooptische Kristalle zeichnen sich dadurch aus, dass die entstehende Schallwelle die optischen Eigenschaften des Kristalls verändert.

Beispiele für solche akustooptischen Elemente, die auch im Rahmen der Erfindung vorteilhaft verwendbar sind, sind akustooptische abstimmbare Filter (AOTF), akustooptische Modulatoren (AOM), akustooptische Ablenker bzw. Deflektoren (AOD), akustooptische Strahlteiler (AOBS) und akustooptische Strahlvereiniger (AOBM).

Eine besondere Herausforderung bei der Verwendung von akustooptischen Elementen stellt deren Ansteuerung dar. Die hochfrequenten elektrischen Signale für den Wandler werden üblicherweise in einem Frequenzgenerator (beispielsweise ein spannungsgesteuerter Oszillator (englisch voltage-controlled oscillator, VCO), eine Phasenregelschleife (englisch phase-locked loop, PLL), oder ein Synthesizer nach dem DDS-Verfahren (direkte digitale Synthese (englisch direct digital synthesis)) erzeugt und mittels Hochfrequenzverstärkers so verstärkt, dass die Amplitude genügend groß ist, um den Kristall in Schwingung zu versetzen. Bei mehreren gleichzeitig angelegten, unterschiedlichen Ansteuerfrequenzen können Lichtstrahlen mehrerer Wellenlängen gleichzeitig (beispielsweise bei einem AOTF, AOBS, AOBM, AOM) beziehungsweise eine Wellenlänge eines einfallenden Lichtstrahls in mehrere Lichtstrahlen verschiedener Richtungen gleichzeitig (beispielsweise bei einem AOD) abgelenkt werden.

Die Durchlassbandbreite akustooptischer Modulatoren kann zum einem durch konstruktive Maßnahmen wie die Ausgestaltung der Kristallgeometrie und/oder des Transducers und zum anderen durch die Kurvenform des Ansteuersignals variiert werden. Beispielsweise können im zweiten Fall mehrere eng zusammen liegende Frequenzen überlagert und in den Kristall eingespeist werden, was eine Überlappung der einzelnen Durchlassbereiche zu einem größeren Durchlassbereich bewirkt.

Nachteilig an diesen Methoden ist, dass bei der konstruktiven Lösung die Verbreiterung der Durchlasskurve nicht veränderbar ist. Wenn verschiedene Durchlassbreiten gewünscht sind, müssen die Kristalle getauscht werden. Weiterhin sind die Durchlassbreiten im gesamten Spektralbereich des Kristalls durch die Geometrie vorgegeben. Bei der Überlagerungslösung entstehen durch hohe Spitzenleistungen, die von dem verwendeten HF-Verstärker verarbeitet werden müssen. Damit der Verstärker durch nichtlineares Verhalten keine Mischprodukte produziert, muss sein linearer Bereich sehr groß sein. Das bedeutet, dass der Verstärker im Vergleich zur mittleren Leistung eine erheblich höhere Spitzenleistung liefern muss. Dies verteuert den Verstärker erheblich. Wenn die Differenzen der Einzelfrequenzen ungünstig zueinander liegen, können Mischprodukte entstehen, was z.B. bei der Verwendung eines Weißlichtlasers als Lichtquelle dazu führt, dass auch unerwünschte Farben eingeschaltet werden.

GB 2 427 034 A offenbart einen akustooptischen Kristall und einen piezoelektrischen Wandler zur Versetzung des aktustooptischen Kristalls in mechanische Schwingungen. Der akustooptische Kristall wird mit zwei verschiedenen Ansteuerfrequenzen angesteuert, wobei das durch Dichteschwankungen erzeugte Gitte gleichzeitig verschiedene Gitterabstände aufweisen kann.

WO 2017/207664 A1 offenbart eine Ansteuerung eines akustooptischen Kristalls mit zwei verschiedenen Frequenzen. Dabei können verschiedene gepulste Lichtstrahlen auf verschiedene Anregungsfrequenzen des akustooptischen Kristalls treffen.

DE 10 2013 201 968 A1 offenbart einen akustooptischen Deflektor, wobei zwei Schwingungsfrequenzen gleichzeitig im Kristall erzeugt werden können.

WO 2018/197546 A1 offenbart ein Verfahren zur Ansteuerung eines akustooptischen Elements mit einem Ansteuersignal, das mittels eines DDS-Verfahrens mit einer Signalwertfolge, die sich aus mindestens zwei Frequenzkomponenten zusammensetzt, erzeugt wird.

JP 2000 149337 A zeigt eine Belichtungsvorrichtung für optische Platten, bei der Laserstrahlen auf eine sich drehende Belichtungsmasterplatte fokussiert werden, auf der ein Photoresist aufgebracht ist, um eine Pit-Reihe oder eine Rille zu belichten. Dabei ist im Strahlengang ein akustooptisches Element angeordnet. Es sind mehrere Hochfrequenzsignalgeneratoren angeordnet, die Treibersignale mit unterschiedlichen Frequenzen an das akustooptische Element anlegen. Ferner sind ein Hochgeschwindigkeitsschaltelement und ein Impulssignalgenerator vorgesehen, die sequentiell und wiederholt eines der von den Hochfrequenzsignalgeneratoren erzeugten Ansteuersignale an das akustooptische Element anlegen.

### Offenbarung der Erfindung

Erfindungsgemäß werden ein Verfahren und ein Signalgenerator zum Ansteuern eines akustooptischen Elements, eine Anordnung aus einem solchen Signalgenerator und einem akustooptischen Element sowie ein Mikroskop mit einer solchen Anordnung mit den Merkmalen der unabhängigen Patentansprüche vorgeschlagen. Vorteilhafte Ausgestaltungen sind Gegenstand der Unteransprüche sowie der nachfolgenden Beschreibung.

Die Erfindung basiert auf der Maßnahme, einen akustooptischen Kristall mit einer Schallwelle zu beaufschlagen, deren Frequenz zeitlich so schnell variiert, dass sich effektiv ein Gitter mit mehreren Gitterkonstanten ausbildet.

Bekanntermaßen führt eine Schallwelle in einem akustooptischen Kristall zu einer Gitterstruktur, deren Gitterkonstante von der Frequenz des Schalls und der Schallgeschwindigkeit im Kristall abhängt. Durchläuft ein Laserstrahl diese Gitterstruktur und passen die Dimensionen der Struktur und die Wellenlänge des Lichtes zusammen, wird ein Teil des Laserlichtes durch einen Beugungsprozess abgelenkt. Längs des Strahlverlaufes im Schallfeld wird kontinuierlich etwas Licht abgelenkt. Betrachtet man die Menge des abgelenkten Lichtes längs eines kleinen Teils des Strahlverlaufes im Schallfeld, so ist diese korreliert mit der Schalleistung und damit der Ausprägung des durch den Schall erzeugten Gitters. Die Amplitude und damit die Ausprägung des Gitters bestimmt somit die Menge des abgelenkten Lichtes. Das Maximum der Menge des abgelenkten Lichtes ist dann erreicht, wenn von der prinzipiell ablenkbaren Menge an der Stelle, an der der Lichtstrahl das Schallfeld verlässt, alles Licht abgelenkt wurde.

Wenn die schallerzeugende Frequenz nicht konstant ist, sondern abwechselnd mehrere verschiedene Werte um eine Mittenfrequenz annimmt, dann entsteht eine Gitterstruktur mit zonenweise wechselnden Gitterkonstanten. Diese mehreren verschiedenen Werte werden im Folgenden auch als Mittenfrequenzspektrum bezeichnet. Die Mittenfrequenz selbst kann, muss aber nicht Bestandteil des Mittenfrequenzspektrums sein.

Jede dieser Zonen lenkt Licht aus einem bestimmten Wellenlängenbereich ab. Da der Lichtstrahl nacheinander mehrere Zonen durchläuft, wird in jeder Zone etwas Licht einer anderen Wellenlänge abgelenkt. Um nun die gleiche Menge an Licht abzulenken wie im monochromatischen Falle, können die Gitterintensität und damit Schalleistung etwas höher sein. Bei einem genügend schnellen Umschalten der Frequenzen existieren immer mehrere Zonen der gleichen Gitterkonstante im Kristall. Es ist dann sichergestellt, dass das Spektrum des abgelenkten Lichtes zeitlich konstant ist.

Damit die Ansteuerfrequenz während eines Durchlaufs einer mechanischen Schwingungswelle durch den akustooptischen Kristall abwechselnd mehrere verschiedene Werte um eine Mittenfrequenz annehmen kann, erfolgt das Umschalten unter Berücksichtigung der Kristallausdehnung und der Schallgeschwindigkeit im Kristall. Aus diesen Größen ergibt sich die Zeit, die eine mechanische Schwingungswelle zum Durchlaufen des Kristalls benötigt und während der die Frequenz des Ansteuersignals wenigstens einmal wenigstens zwei unterschiedliche Werte annehmen muss. Vorzugsweise nimmt sie jedoch während dessen mehrmals die wenigstens zwei unterschiedlichen Werte an.

Vorzugsweise nimmt die Ansteuerfrequenz zwei bis acht verschiedene Werte an. Dies ist praktikabel, da auf diese Weise unterschiedliche Wellenlängenbereiche von Licht abgelenkt werden können, gleichzeitig aber die Umschaltung schnell genug erfolgen kann, damit die Intensität des jeweils abgelenkten Lichtes ausreichend groß ist. Vorzugsweise befinden sich die mehreren verschiedenen Werte in einer Bandbreite von 50 kHz - 1 MHz um die Mittenfrequenz.

Insbesondere weist das Ansteuersignal für jede Ansteuerfrequenz eine konstante Amplitude auf. Jedoch sind auch unterschiedliche Amplituden für die unterschiedlichen Ansteuerfrequenzen denkbar. Insbesondere kann es vorteilhaft sein, bei höheren Frequenzen aufgrund des Dämpfungsverhaltens eine höhere Amplitude anzulegen.

Weitere Vorteile und Ausgestaltungen der Erfindung ergeben sich aus der Beschreibung und der beiliegenden Zeichnung.

Eine geeignete Art der Umschaltung sollte sprungfrei sein, d.h. der Kurvenzug des Ansteuersignals der Schallerzeugung sollte kontinuierlich sein. Anderenfalls würden unerwünschte Oberwellen erzeugt. Weiterhin sollte eine Frequenz mindestens eine komplette Periode lang anliegen, vorzugsweise eine Mehrzahl von kompletten Perioden, um eine eindeutige Gitterstruktur aufzubauen.

Durch das abwechselnde Anlegen von unterschiedlichen Frequenzen ist sichergestellt, dass aus jedem Mittenfrequenzspektrum immer nur eine Frequenz in einem Zeitintervall am Kristall anliegt. Es ist also nicht möglich, mit anderen Frequenzen Intermodulationsprodukte zu bilden. Auch ist es nicht möglich, durch Schwebungen hohe Leistungsspitzen zu erzeugen.

Vorteilhaft wird die wenigstens eine Ansteuerfrequenz periodisch derart schnell verändert, dass ein Lichtstrahl, der - insbesondere nicht senkrecht zu der mechanischen Schwingungswelle - in den akustooptischen Kristall einfällt, mindestens zweimal auf den gleichen Gitterabstand trifft. Es ist dadurch sichergestellt, dass das Spektrum des abgelenkten Lichtes zeitlich konstant ist. Gemäß der Erfindung wird die wenigstens eine Ansteuerfrequenz periodisch derart schnell verändert, dass der Lichtstrahl mindestens drei oder mehrmals auf den gleichen Gitterabstand trifft. Auf diese Weise kann eine Gleichmäßigkeit der Lichtablenkung noch verbessert werden.

Da der Kristall Dichtefelder superponieren kann, ist es möglich, dieses Verfahren mit verschiedenen Mittenfrequenzen gleichzeitig im gleichen Kristall anzuwenden. Wenn die Mittenfrequenzen entsprechend weit auseinanderliegen, bleiben obige Vorteile des Verfahrens weitgehend erhalten.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung ist anhand eines Ausführungsbeispiels in der Zeichnung schematisch dargestellt und wird im Folgenden unter Bezugnahme auf die Zeichnung beschrieben.

### Figurenbeschreibung

- Figur 1: zeigt eine Anordnung gemäß einer Ausführungsform der Erfindung,
- Figur 2: zeigt einen Verlauf eines Ansteuersignals für einen piezoelektrischen Wandler gemäß einer Ausführungsform eines erfindungsgemäßen Verfahrens,
- Figur 3: zeigt ein akustooptisches Element, das gemäß einer Ausführungsform eines erfindungsgemäßen Verfahrens angesteuert wird,
- Figur 4: zeigt eine Übersicht über die typischen Elemente eines konfokalen Mikroskops in schematischer Ansicht.

### Detaillierte Beschreibung der Zeichnungen

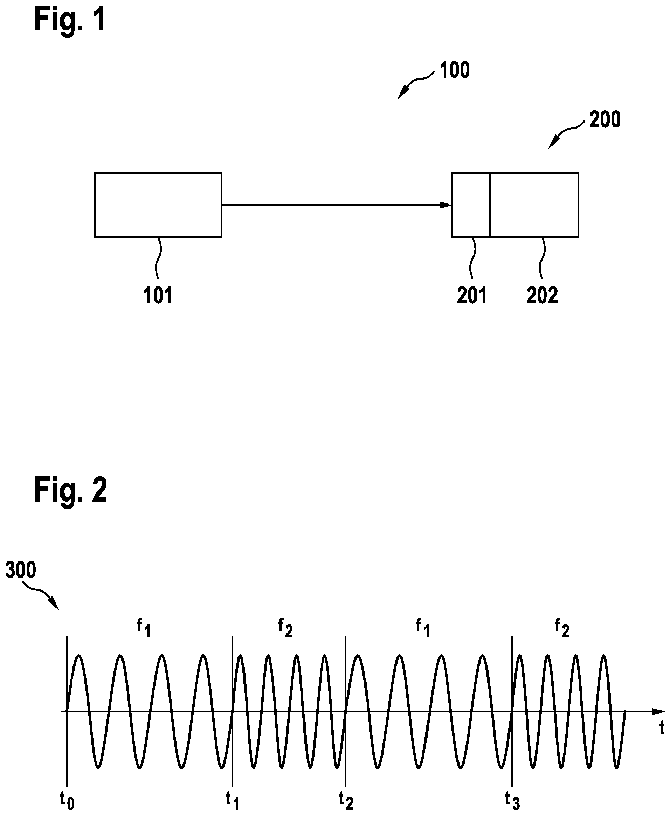

Figur 1 zeigt schematisch eine Anordnung 100 gemäß einer bevorzugten Ausführungsform der Erfindung.

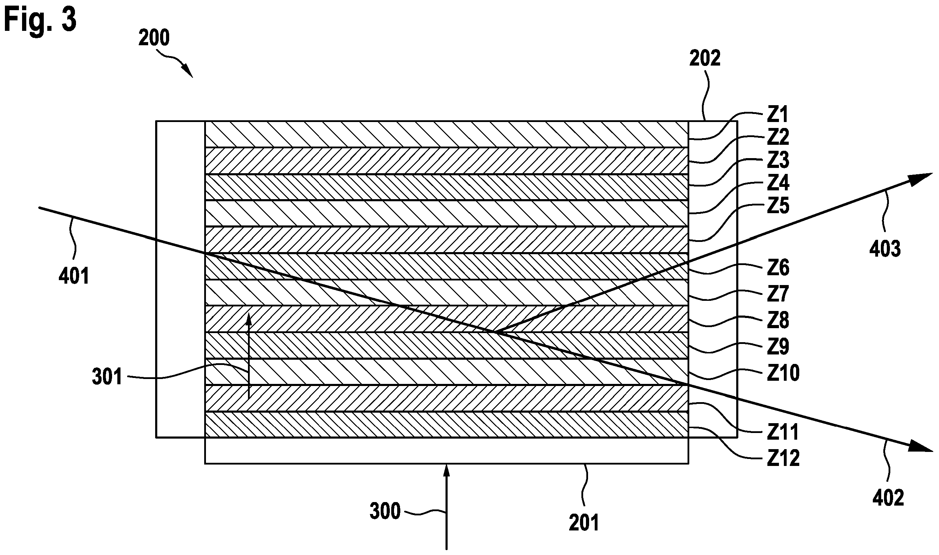

Die Anordnung 100 umfasst einen Signalgenerator 101. Dieser dient zur Ansteuerung eines akustooptischen Elements 200, welches einen akustooptischen Kristall 202 und einen piezoelektrischen Wandler 201 zur Versetzung des Kristalls 202 in mechanische Schwingungen aufweist. Das akustooptische Element dient zur Beeinflussung von Licht in einer gewünschten Art und Weise, z.B. als AOTF. Die mechanischen Schwingungen bewirken Dichteschwankungen im Kristall, die als optisches Gitter fungieren, wie in Figur 3 angedeutet.

Der Signalgenerator 101 ist dazu eingerichtet, den piezoelektrischen Wandler 201 mit einem Ansteuersignal 300 mit wenigstens einer Ansteuerfrequenz f anzusteuern, wobei die wenigstens eine Ansteuerfrequenz f während eines Durchlaufs einer mechanischen Schwingungswelle 301 durch den akustooptischen Kristall 202 abwechselnd mehrere verschiedene Werte um eine Mittenfrequenz annimmt, so dass ein durch Dichteschwankungen im akustooptischen Kristall 202 erzeugtes Gitter gleichzeitig verschiedene Gitterabstände aufweist.

Figur 2 zeigt beispielhaft ein solches Ansteuersignal 300. Es ist zu sehen, dass die Ansteuerfrequenz f abwechselnd zwei verschiedene Werte f₁, f₂ annimmt. Sie nimmt insbesondere zwischen Zeitpunkt t₀ und Zeitpunkt t₁ den Wert f₁ an, zwischen t₁ und t₂ den Wert f₂, zwischen t₂ und t₃ den Wert f₁ und zwischen t₃ und t₄ den Wert f₂ an. Obwohl die Werte der Ansteuerfrequenz f₁, f₂ abwechseln, ist der Kurvenzug des Ansteuersignals 300 dennoch kontinuierlich und sprungfrei. Weiterhin ist zu sehen, dass die Ansteuerfrequenz f des Ansteuersignals 300 immer jeweils wenigstens eine Schwingungsdauer konstant ist, genauer gesagt in diesem Beispiel jeweils genau vier Schwingungsdauern.

Figur 3 zeigt ein akustooptisches Element 200, das gemäß einer Ausführungsform eines erfindungsgemäßen Verfahrens angesteuert wird. Das akustooptische Element 200 weist einen akustooptischen Kristall 202 und einen piezoelektrischen Wandler 201 zur Versetzung des Kristalls 202 in mechanische Schwingungen auf. Der piezoelektrische Wandler 201 wird mit einem Ansteuersignal 300 mit wenigstens einer Ansteuerfrequenz f angesteuert, wobei die wenigstens eine Ansteuerfrequenz f während eines Durchlaufs einer mechanischen Schwingungswelle durch den akustooptischen Kristall 202 hier abwechselnd drei verschiedene Werte annimmt.

Es bildet sich eine mechanische Schwingungswelle 301 aus, die sich durch den akustooptischen Kristall 202 als akustische Schallwelle fortsetzt. Es entsteht eine Gitterstruktur mit zonenweise wechselnden Gitterkonstanten, wobei in Figur 3 die Gitterstruktur für einen bestimmten Zeitpunkt dargestellt ist.

Die Zonen sind mit unterschiedlichen Schraffuren gekennzeichnet und mit z1, z2, z3, z4, z5, z6, z7, z8, z9, z10, z11 und z12 bezeichnet. Immer nach drei Zonen wiederholt sich eine Gitterkonstante. Auf diese Weise weisen sowohl Zonen z1, z4, z7 und z10 als auch Zonen z2, z5, z 8 und z11 als auch Zonen z3, z6, z9 und z12 jeweils die gleiche Gitterkonstante auf. Dies ist in der Figur dadurch dargestellt, dass Zonen mit gleicher Gitterkonstante jeweils die gleiche Schraffur aufweisen.

Der akustooptische Kristall dient zur Ablenkung von Lichtstrahlen. Durchläuft ein Lichtstrahl diese Gitterstruktur und passen die Dimensionen der Struktur und die Wellenlänge des Lichtes zusammen, wird ein Teil des Lichtstrahls durch einen Beugungsprozess abgelenkt. Jede dieser Zonen lenkt Licht eines bestimmten Wellenlängenbereichs ab. Da der Lichtstrahl nacheinander mehrere Zonen z1, ..., z12 durchläuft, wird in jeder Zone etwas Licht einer anderen Wellenlänge abgelenkt. Ein einfallender Lichtstrahl ist eingezeichnet und mit 401 bezeichnet. Ein nicht abgelenkter Lichtstrahl ist mit 402 bezeichnet. Ein abgelenkter Lichtstrahl ist mit 403 bezeichnet.

Vorteilhaft wird die wenigstens eine Ansteuerfrequenz 300 periodisch derart schnell verändert, dass ein Lichtstrahl 401, der in den akustooptischen Kristall 202 einfällt, mindestens zweimal auf den gleichen Gitterabstand trifft. Dies ist bei dem eingezeichneten einfallenden Lichtstrahl 401 z.B. für die Zonen z6 und z9 bzw. z7 und z10 der Fall.

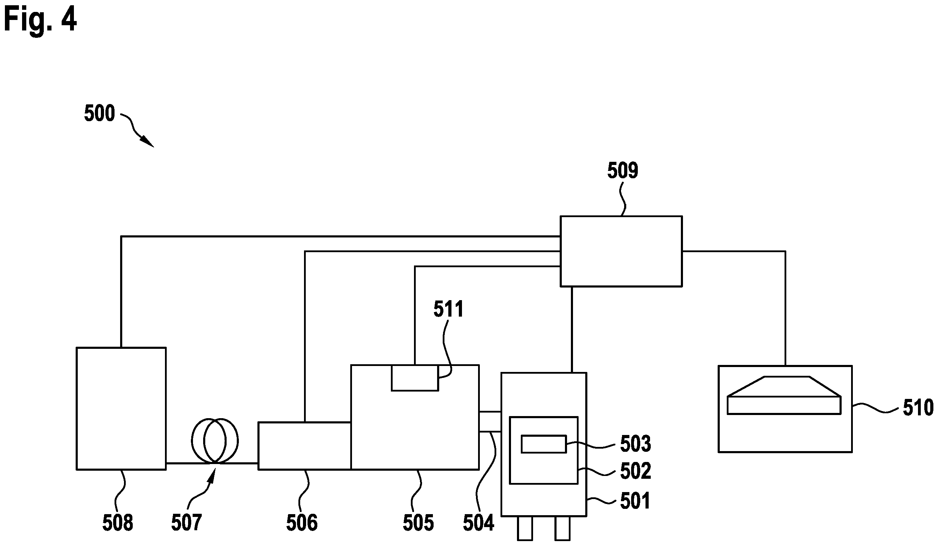

Figur 4 zeigt schematisch ein Konfokalmikroskop mit typischen Komponenten. 500 bezeichnet das Gesamtsystem. Die konfokale Raster- und Detektionseinheit ist mit 505 bezeichnet. Die dazugehörige Beleuchtungseinrichtung ist mit 506 bezeichnet. In der Beleuchtungseinrichtung ist eine Anordnung gemäß Figur 1 vorgesehen.

Bei 508 handelt es sich um eine Laserlichtquelle, die über eine Beleuchtungsfaser 507 mit der Beleuchtungseinrichtung 506 verbunden ist. Das Laserlicht wird in der Beleuchtungseinrichtung 506 gewünschtenfalls mittels eines akustooptischen Elements beeinflusst.

504 bezeichnet einen optischen Adapter für die konfokale Raster- und Detektionseinheit 505 am Mikroskopstativ 501. Innerhalb des Stativs 501 befindet sich der Objekttisch 502 mit einer zu untersuchenden Probe 503. Eine Steuereinheit 509 steht über entsprechende Verbindungsleitungen mit den einzelnen Komponenten 508, 506, 505 und 501 in Verbindung. Ein Rechner mit Steuer- und Darstellungsprogrammen ist mit 510 bezeichnet; auch er steht mit der Steuereinheit 509 in Verbindung.

Innerhalb der konfokalen Raster- und Detektionseinheit 505 ist in einer ersten Variante ein klassischer konfokaler Strahlengang angeordnet, der in bekannter Weise mit einem einzelnen Pinhole und einem Strahlscanner, beispielsweise einem Spiegelscanner, aufgebaut ist.

In einer zweiten Variante befindet sich innerhalb der konfokalen Raster- und Detektionseinheit 505 ein Strahlengang, bei dem die Probe gleichzeitig mit einem oder mehreren oder in einer Richtung ausgedehnten Beleuchtungspunkten beleuchtet wird. Entsprechend werden die zu detektierenden Photonen beispielsweise mit einer geometrischen Anordnung von Lochblenden (Pinholes) selektiert.

Die zu untersuchende Probe 503 wird über eine Mikroskopoptik beleuchtet, sowie über dieselbe Mikroskopoptik insbesondere auf eine Sensoranordnung 511 abgebildet, die je nach Ausführungsform der konfokalen Raster- und Detektionseinheit 505 aus einem Photomultiplier oder einem Array von Photomultipliern besteht. Die Funktionsweise eines in Figur 4 dargestellten Systems 500 ist an sich hinlänglich bekannt und soll daher vorliegend nicht erläutert werden.

### Bezugszeichenliste

- 100: Anordnung
- 101: Signalgenerator
- 200: akustooptisches Element
- 201: piezoelektrischer Wandler
- 202: akustooptischer Kristall

- 300: Ansteuersignal
- 301: mechanische Schwingungswelle
- 401: einfallender Lichtstrahl
- 402: nicht abgelenkter Lichtstrahl
- 403: abgelenkter Lichtstrahl

- 500: Mikroskopsystem
- 501: Mikroskopstativ mit Mikroskopoptik
- 502: Objekttisch
- 503: Probe
- 504: optischer Adapter
- 505: konfokale Raster- und Detektionseinheit
- 506: Beleuchtungseinrichtung
- 507: Beleuchtungsfaser
- 508: Laserlichtquelle
- 509: Steuereinheit mit Signalgenerator
- 510: Rechner mit Steuer- und Darstellungsprogrammen
- 511: Sensoranordnung

## Patentansprüche

1. Verfahren zur Ansteuerung eines akustooptischen Elements (200) mit einem akustooptischen Kristall (202) und einem piezoelektrischen Wandler (201) zur Versetzung des akustooptischen Kristalls (202) in mechanische Schwingungen,
wobei der piezoelektrische Wandler (201) mit einem Ansteuersignal (300) mit wenigstens einer Ansteuerfrequenz angesteuert wird,
wobei die wenigstens eine Ansteuerfrequenz während eines Durchlaufs einer mechanischen Schwingungswelle (301) durch den akustooptischen Kristall (202) abwechselnd mehrere verschiedene Werte (f₁, f₂) um eine Mittenfrequenz annimmt, so dass ein durch Dichteschwankungen im akustooptischen Kristall (202) erzeugtes Gitter gleichzeitig verschiedene Gitterabstände aufweist,
wobei die wenigstens eine Ansteuerfrequenz periodisch derart schnell verändert wird, dass immer mehrere Zonen mit dem gleichen Gitterabstand im akustooptischen Kristall existieren,
wobei der akustooptische Kristall (202) mit einem Lichtstrahl (401) bestrahlt wird,
**dadurch gekennzeichnet, dass** der Lichtstrahl (401), der in den akustooptischen Kristall (202) einfällt, mindestens dreimal auf eine Zone mit dem gleichen Gitterabstand trifft

2. Verfahren nach Anspruch 1, wobei sich die mehreren verschiedenen Werte (f₁, f₂) in einer Bandbreite von 50 kHz - 1 MHz um die Mittenfrequenz befinden.

3. Verfahren nach einem der vorstehenden Ansprüche, wobei die mehreren verschiedenen Werte (f₁, f₂) um die Mittenfrequenz insgesamt drei bis zehn Werte umfassen.

4. Verfahren nach einem der vorstehenden Ansprüche, wobei die wenigstens eine Ansteuerfrequenz jeweils für mindestens eine, vorzugsweise für mehrere komplette Schwingungsdauern der Ansteuerfrequenz konstant ist

5. Verfahren nach einem der vorstehenden Ansprüche, wobei das Ansteuersignal (300) gleichzeitig mehrere Ansteuerfrequenzen aufweist, die jeweils verschiedene Werte um jeweils eine Mittenfrequenz annehmen.

6. Verfahren nach einem der vorstehenden Ansprüche, wobei ein Kurvenzug des Ansteuersignals (300) kontinuierlich und sprungfrei ist

7. Anordnung (100) aus wenigstens einem Signalgenerator (101) zum Ansteuern eines akustooptischen Elements (200), der dazu eingerichtet ist, ein Verfahren nach einem der vorstehenden Ansprüche durchzuführen, einem akustooptischen Element (200) und einer Laserlichtquelle (508).

8. Anordnung (100) nach Anspruch 7, wobei das akustooptische Element (200) ausgewählt ist aus einem akustooptisch abstimmbaren Filter, einem akustooptischen Modulator, einem akustooptischen Ablenker, einem akustooptischen Strahlteiler und einem akustooptischen Strahlvereiniger.

9. Mikroskop (500) mit einer Anordnung (100) nach Anspruch 7 oder 8.

## Claims

1. Method of driving an acousto-optic element (200) comprising an acousto-optic crystal (202) and a piezoelectric transducer (201) for causing the acousto-optic crystal (202) to vibrate mechanically,
wherein the piezoelectric transducer (201) is driven by a drive signal (300) with at least one driving frequency,
wherein the at least one driving frequency alternately assumes several different values (f₁, f₂) around a centre frequency during a passage of a mechanical oscillation wave (301) through the acousto-optic crystal (202), so that a grating generated by density fluctuations in the acousto-optic crystal (202) simultaneously has different grating spacings,
wherein the at least one driving frequency is periodically changed so quickly that there are always several zones with the same grating spacing in the acousto-optic crystal,
wherein the acousto-optic crystal (202) is irradiated with a light beam (401),
**characterised in that** the light beam (401) which enters the acousto-optic crystal (202) strikes a zone with the same grating spacing at least three times.

2. Method according to claim 1, wherein the several different values (f₁, f₂) are located in a bandwidth of 50 kHz - 1 MHz around the centre frequency.

3. Method according to one of the preceding claims, wherein the several different values (f₁, f₂) around the centre frequency comprise a total of three to ten values.

4. Method according to one of the preceding claims, wherein the at least one driving frequency is constant for at least one, preferably for several complete oscillation durations of the driving frequency.

5. Method according to one of the preceding claims, wherein the drive signal (300) simultaneously has a plurality of driving frequencies, each of which assumes different values around a centre frequency.

6. Method according to one of the preceding claims, wherein a curve of the drive signal (300) is continuous and jump-free.

7. Arrangement (100) comprising at least one signal generator (101) for driving an acousto-optic element (200), which is adapted to perform a method according to one of the preceding claims, an acousto-optic element (200) and a laser light source (508).

8. Arrangement (100) according to claim 7, wherein the acousto-optic element (200) is selected from an acousto-optically tunable filter, an acousto-optic modulator, an acousto-optic deflector, an acousto-optic beam splitter and an acousto-optic beam combiner.

9. Microscope (500) having an arrangement (100) according to claim 7 or 8.

## Revendications

1. Méthode de commande d'un élément acousto-optique (200) comprenant un cristal acousto-optique (202) et un transducteur piézoélectrique (201) pour faire vibrer mécaniquement le cristal acousto-optique (202),
dans lequel le transducteur piézoélectrique (201) est commandé par un signal de commande (300) ayant au moins une fréquence de commande,
l'au moins une fréquence de commande prenant alternativement plusieurs valeurs différentes (f₁ , f₂ ) autour d'une fréquence centrale pendant un passage d'une onde d'oscillation mécanique (301) à travers le cristal acousto-optique (202), de sorte qu'un réseau généré par des variations de densité dans le cristal acousto-optique (202) présente simultanément différentes distances de réseau,
ladite au moins une fréquence de commande étant modifiée périodiquement et rapidement de telle sorte qu'il existe toujours plusieurs zones ayant le même espacement de réseau dans le cristal acousto-optique,
dans lequel le cristal acousto-optique (202) est irradié par un faisceau lumineux (401),
**caractérisé en ce que** le faisceau lumineux (401) qui est incident dans le cristal acousto-optique (202) rencontre au moins trois fois une zone ayant le même espacement de réseau.

2. Méthode selon la revendication 1, dans lequel les multiples valeurs différentes (f₁ , f₂ ) se trouvent dans une largeur de bande de 50 kHz - 1 MHz autour de la fréquence centrale.

3. Méthode selon l'une quelconque des revendications précédentes, dans lequel la pluralité de valeurs différentes (f₁ , f₂ ) autour de la fréquence centrale comprend un total de trois à dix valeurs.

4. Méthode selon l'une quelconque des revendications précédentes, dans lequel la au moins une fréquence de commande est respectivement constante pour au moins une, de préférence pour plusieurs durées d'oscillation complètes de la fréquence de commande.

5. Méthode selon l'une quelconque des revendications précédentes, dans lequel le signal de commande (300) présente simultanément plusieurs fréquences de commande qui prennent chacune des valeurs différentes autour d'une fréquence centrale respective.

6. Méthode selon l'une des revendications précédentes, dans lequel un tracé de courbe du signal de commande (300) est continu et sans saut

7. Ensemble (100) constitué d'au moins un générateur de signaux (101) pour la commande d'un élément acousto-optique (200), qui est adapté pour mettre en oeuvre un méthode selon l'une des revendications précédentes, d'un élément acousto-optique (200) et d'une source de lumière laser (508).

8. Ensemble (100) selon la revendication 7, dans lequel l'élément acousto-optique (200) est choisi parmi un filtre accordable acousto-optique, un modulateur acousto-optique, un déflecteur acousto-optique, un séparateur de faisceau acousto-optique et un unificateur de faisceau acousto-optique.

9. Microscope (500) avec un ensemble (100) selon la revendication 7 ou 8.
